# EUROPEAN PATENT APPLICATION

(11) **EP 4 783 793 A1**
(43) Date of publication of application: **29.07.2026**
(21) Application number: 26150708.1
(22) Date of filing: 08.01.2026
(51) Int. Cl.: H10H 29/855, H10H 29/80

(54) **LIGHT SOURCE MODULE AND DISPLAY DEVICE INCLUDING THE SAME**

(30) Priority: 24.01.2025 KR 20250011902
(71) Applicant: Samsung Electronics Co., Ltd., Suwon-si, Gyeonggi-do 16677 (KR)
(72) Inventor: SUL, Sangchul, 16677 Suwon-si, Gyeonggi-do (KR)
(74) Representative: Kuhnen & Wacker Patent- und Rechtsanwaltsbüro PartG mbB

(57) **Abstract**

A light source module (10) includes a substrate (101), a light emitter (110) on the substrate (101) and including a pixel array (110) including a plurality of light-emitting structures (110R, 110G, 110B) configured to emit light (LR, LG, LB), an optical spacer layer (120) on the light emitter (110) and covering the light emitter (110), and a meta-microlens (130) on the optical spacer layer (120) and including a plurality of pillar structures (133) configured to refract, in predetermined directions, the light (LR, LG, LB) emitted from the plurality of light-emitting structures (110R, 110G, 110B), where the plurality of pillar structures (133) are respectively arranged in a plurality of layouts, the plurality of layouts respectively corresponding to the plurality of light-emitting structures (110R, 110G, 110B) and the plurality of pillar structures (133) in each of the plurality of layouts are configured to independently adjust angles of refraction of the light (LR, LG, LB) respectively emitted from the plurality of light-emitting structures (110R, 110G, 110B).

## Description

### BACKGROUND

The present disclosure relates to a light source module and a display device including the light source module.

Light-emitting diodes (LEDs) are light sources that convert electrical energy into optical energy and have been widely used as light sources for various display devices, such as a lighting device, a television (TV), a mobile phone, a personal computer (PC), a laptop, a personal digital assistant (PDA), a digital camera, a camcorder, a viewfinder, a flat panel display, a 3D display, and an augmented reality display. Recently, micro-sized or nano-sized ultra-small light-emitting diodes have been developed, and thus, development of a light source module having a structure to improve the light extraction efficiency of the ultra-small light-emitting diodes is being pursued.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments provide a light source module having a structure that may be capable of improving light uniformity and a display device including the light source module.

Additional aspects will be set forth in part in the description which follows and, in part, will be apparent from the description, or may be learned by practice of the presented embodiments.

According to an aspect of an example embodiment, a light source module may include a substrate, a light emitter on the substrate and including a pixel array including a plurality of light-emitting structures configured to emit light, an optical spacer layer on the light emitter and covering the light emitter, and a meta-microlens on the optical spacer layer and including a plurality of pillar structures configured to refract, in predetermined directions, the light emitted from the plurality of light-emitting structures, where the plurality of pillar structures are respectively arranged in a plurality of layouts, the plurality of layouts respectively corresponding to the plurality of light-emitting structures and the plurality of pillar structures in each of the plurality of layouts are configured to independently adjust angles of refraction of the light respectively emitted from the plurality of light-emitting structures.

According to an aspect of an example embodiment, a light source module may include a substrate, a light emitter on the substrate and including a pixel array including a plurality of light-emitting structures configured to emit white light, an optical spacer layer on the light emitter and covering the light emitter, a meta-color filter on the optical spacer layer and including a plurality of unit pillar structures configured to separate the white light emitted from the plurality of light-emitting structures into light of different colors, and a meta-microlens on the meta-color filter and including a plurality of cylindrical pillar structures configured to refract, in predetermined directions, the light of different colors separated by the meta-color filter, where each of the plurality of unit pillar structures includes at least one pillar extending in a vertical direction, the plurality of cylindrical pillar structures are respectively arranged in a plurality of layouts respectively corresponding to the plurality of light-emitting structures, and the plurality of cylindrical pillar structures in each of the plurality of layouts are configured to independently adjust angles of refraction of the light of different colors separated by the meta-color filter.

According to an aspect of an example embodiment, a display device may include a driving circuit board including a plurality of wiring lines and a plurality of transistors, and a light source module on the driving circuit board, where the light source module may include a light emitter including a pixel array including a plurality of light-emitting structures configured to emit light, a plurality of contact plugs respectively connected to the plurality of light-emitting structures, an optical spacer layer on the light emitter and covering the light emitter, and a meta-microlens on the optical spacer layer and including a plurality of pillar structures configured to refract, in predetermined directions, the light emitted from the plurality of light-emitting structures, where the plurality of pillar structures are respectively arranged in a plurality of layouts, the plurality of layouts respectively corresponding to the plurality of light-emitting structures, the plurality of pillar structures in each of the plurality of layouts are configured to independently adjust angles of refraction of the light respectively emitted from the plurality of light-emitting structures, and the plurality of light-emitting structures are connected to the plurality of transistors via the plurality of contact plugs and the plurality of wiring lines.

According to an aspect of an example embodiment, a method of manufacturing a light source module may include forming a board structure including a plurality of light-emitting structures on a substrate, bonding the board structure on a circuit board, removing the substrate, forming an optical spacing layer on upper surfaces of the plurality of light-emitting structures, forming a pattern forming layer on the optical spacing layer, forming a plurality of holes in the pattern forming layer, and forming a plurality of pillar structures by filling the plurality of holes with a material that is different from a material of the pattern forming layer.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1 is a cross-sectional view of a light source module according to one or more embodiments;
FIG. 2 is a diagram of a meta-microlens according to one or more embodiments;
FIGS. 3 and 4 are diagrams of a meta-microlens corresponding to a curved microlens according to one or more embodiments;
FIG. 5 is a diagram of a layout of meta-microlenses capable of independently adjusting angles of refraction of light according to light according to one or more embodiments;
FIG. 6 is diagram illustrating intensities of light according to positions on a light emitter of FIG. 5 according to one or more embodiments;
FIG. 7 is a cross-sectional view of a light source module according to one or more embodiments;
FIG. 8 is a diagram of a meta-microlens and a meta-color filter according to one or more embodiments;
FIGS. 9 and 10 are cross-sectional views of light source modules according to one or more embodiments;
FIGS. 11, 12, 13, 14, 15, 16, 17, 18 and 19 are cross-sectional views illustrating a method of manufacturing a light source module, according to one or more embodiments;
FIG. 20 is a block diagram of an electronic device including a light source module according to one or more embodiments;
FIG. 21 is a diagram of a wearable device as an electronic device including a light source module according to one or more embodiments;
FIG. 22 is a diagram of augmented reality goggles as an electronic device including a light source module according to one or more embodiments;
FIG. 23 is a diagram of a mobile device as an electronic device including a light source module according to one or more embodiments;
FIG. 24 is a diagram of a head-up display device as an electronic device including a light source module according to one or more embodiments; and
FIG. 25 is a diagram of a large signage as an electronic device including a light source module according to one or more embodiments.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

For convenience of understanding, the terms described as an upper surface/a lower surface, an upper portion/a lower portion, up/down, etc. are used based on the directions shown in the referenced diagram. Therefore, even the same surface may be differently referred to as the upper surface or the lower surface depending on the direction shown in the diagram.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

Terms such as first, second, etc. may be used to describe various components, but are used only for the purpose of distinguishing one component from another component. These terms do not limit the difference in the material or structure of the components.

The terms of a singular form may include plural forms unless otherwise specified. In addition, when a certain part "includes" a certain component, it means that other components may be further included rather than excluding other components unless otherwise stated.

The use of the term "the" and similar designating terms may correspond to both the singular and the plural.

Operations of a method may be performed in an appropriate order unless explicitly described in terms of order. In addition, the use of all illustrative terms (e.g., etc.) is merely for describing technical ideas in detail, and the scope is not limited by these examples or illustrative terms unless limited by the claims.

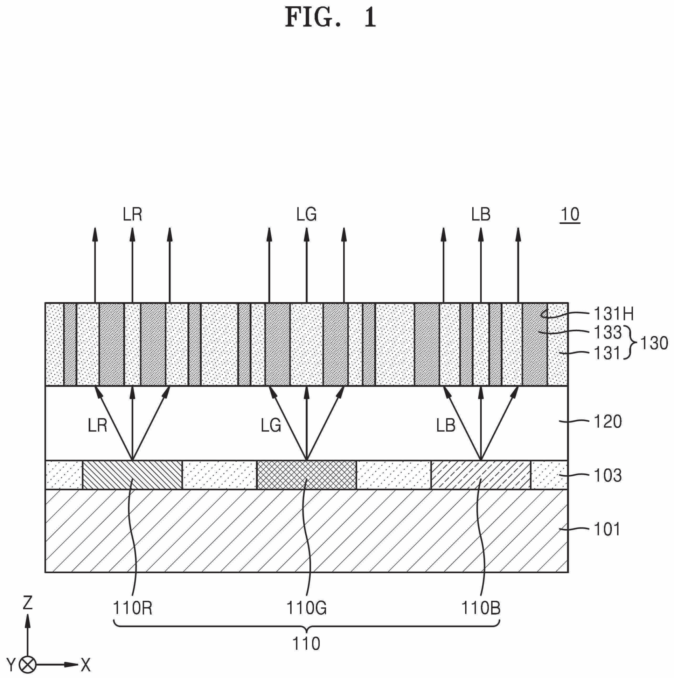

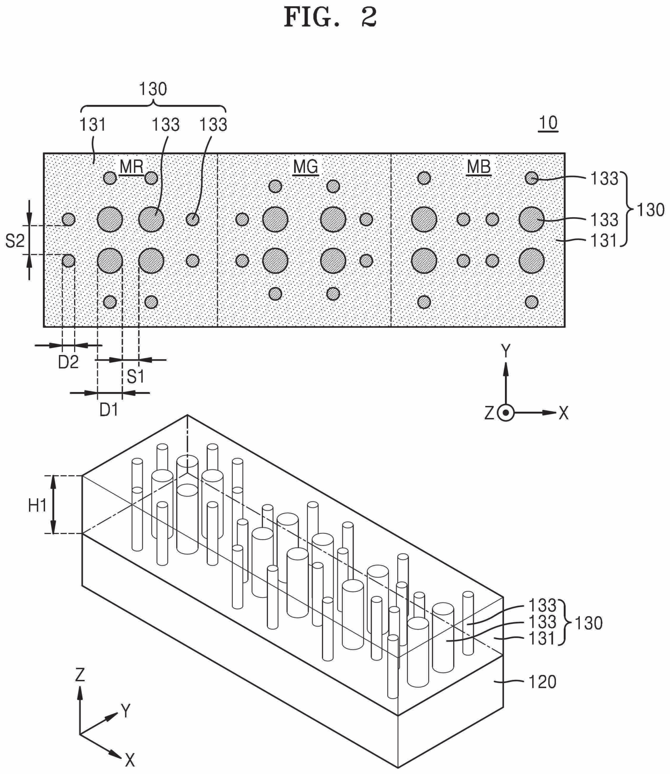

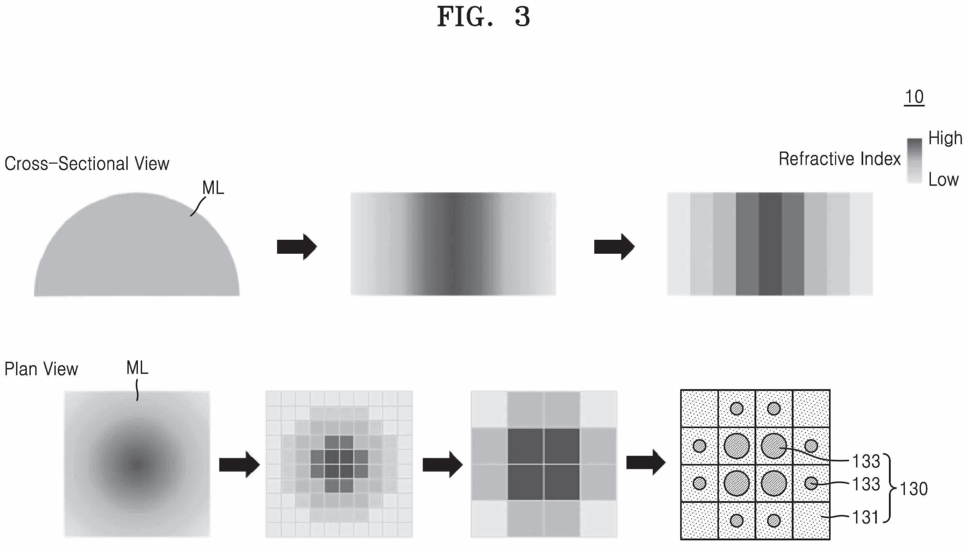

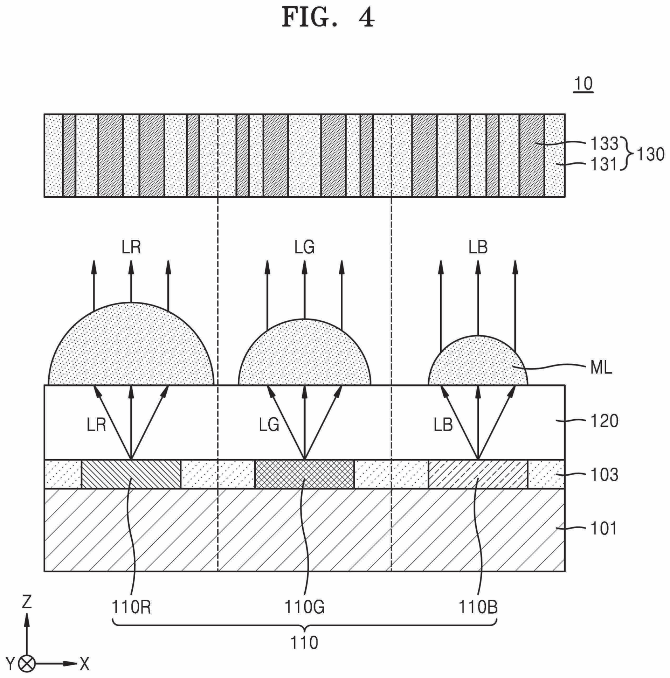

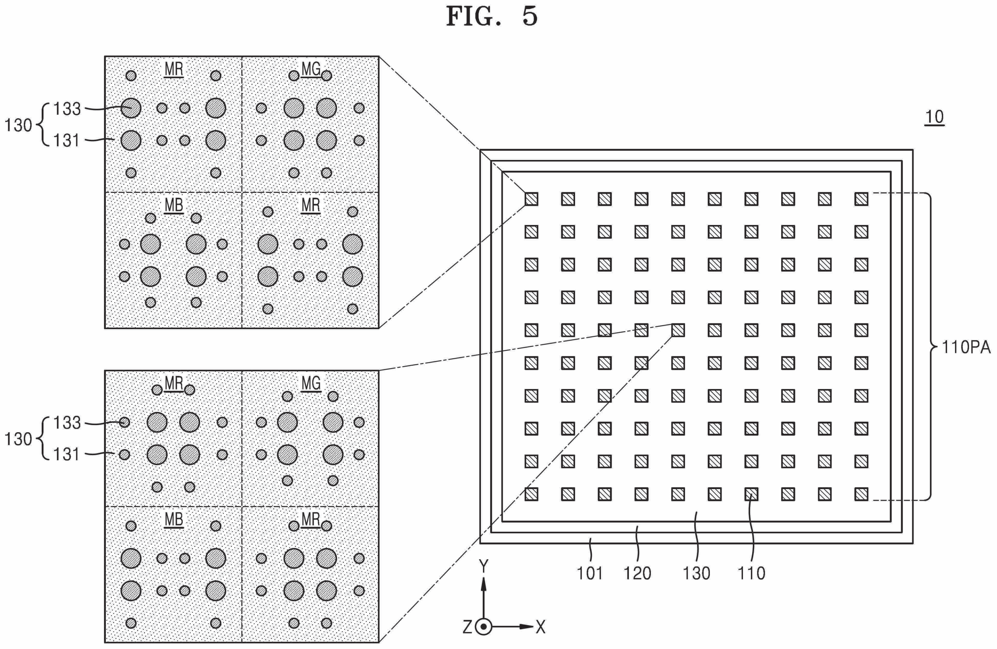

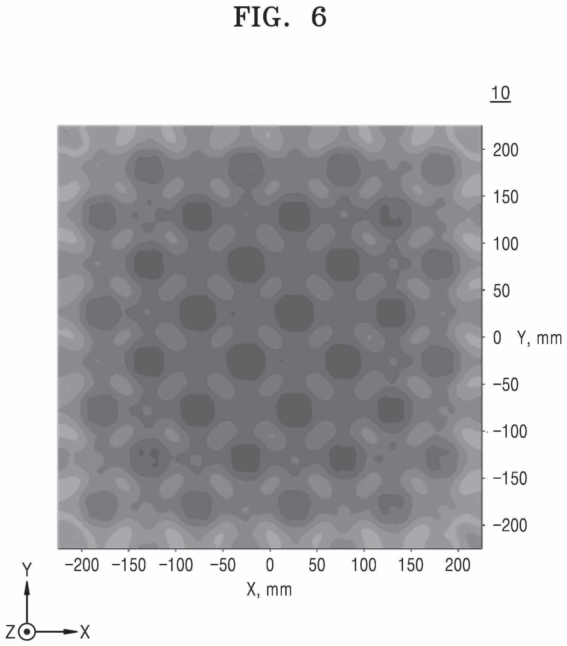

FIG. 1 is a cross-sectional view of a light source module 10 according to one or more embodiments. FIG. 2 is a diagram of a meta-microlens 130 of FIG. 1 in various points of view according to one or more embodiments. FIGS. 3 and 4 are diagrams of the meta-microlens 130 corresponding to a curved microlens according to one or more embodiments. FIG. 5 is a diagram showing a layout of meta-microlenses 130 capable of independently adjusting angles of refraction of light according to light in FIG. 1 according to one or more embodiments. FIG. 6 is diagram illustrating intensities of light according to positions on a light emitter 110 of FIG. 5 according to one or more embodiments.

Referring to FIGS. 1 to 6 together, the light source module 10 according to one or more embodiments may include a substrate 101, a peripheral insulating layer 103, the light emitter 110, an optical spacer layer 120, and the meta-microlens 130.

As shown in FIGS. 1 and 2, the substrate 101 may be electrically connected to the light emitter 110 and transmit a control signal. The substrate 101 may include, for example, a semiconductor wafer or a printed circuit board (PCB).

The peripheral insulating layer 103 may be formed on the substrate 101. The peripheral insulating layer 103 may insulate each of a plurality of light-emitting structures 110R, 110G, and 110B, which are described below. The peripheral insulating layer 103 may include an insulating material and is located around the plurality of light-emitting structures 110R, 110G, and 110B to surround the same.

The light emitter 110 may include a pixel array 110PA in which the plurality of light-emitting structures 110R, 110G, and 110B capable of emitting light LR, LG, and LB of different colors are arranged in a matrix form. The light emitter 110 may, for example, emit light by selecting at least one of the plurality of light-emitting structures 110R, 110G, and 110B. The light emitter 110 may be disposed on one surface of the substrate 101.

Each of the plurality of light-emitting structures 110R, 110G, and 110B may include a light-emitting diode (LED). In one or more embodiments, the plurality of light-emitting structures 110R, 110G, and 110B may include micro LEDs. Here, a micro LED may be an LED having a width of about 100 micrometers (µm) or less in a horizontal direction X or Y.

The plurality of light-emitting structures 110R, 110G, and 110B may be configured to emit light of a wavelength (λ) selected in a range from about 400 nm to about 700 nm. The plurality of light-emitting structures 110R, 110G, and 110B may include a red light-emitting structure for emitting red light, a green light-emitting structure for emitting green light, and a blue light-emitting structure for emitting blue light (hereinafter, the plurality of light-emitting structures 110R, 110G, and 110B may also be referred to as a red light-emitting structure 110R, a green light-emitting structure 110G, and a blue light-emitting structure 110B, and the light LR, LG, and LB may also be referred to as red light LR, green light LG, and blue light LB).

The red light-emitting structure 110R may be configured to emit the red light LR selected in a range of about 580 nm (nanometers) to about 700 nm. A wavelength range of the red light LR may represent a wavelength range of greater than or equal to about 580 nm and less than about 700 nm, and may have at least one light-emitting spectrum peak in the wavelength range of the red light LR.

The green light-emitting structure 110G may be configured to emit the green light LG selected in a range of about 490 nm to about 580 nm. A wavelength range of the green light LG may represent a wavelength range of greater than or equal to about 490 nm and less than about 580 nm, and may have at least one light-emitting spectrum peak in the wavelength range of the green light LG.

The blue light-emitting structure 110B may be configured to emit the blue light LB selected in a range of about 400 nm to about 490 nm. A wavelength range of the blue light LB may represent a wavelength range of greater than or equal to about 400 nm and less than about 490 nm, and may have at least one light-emitting spectrum peak in the wavelength range of the blue light LB.

In one or more embodiments, the light LR, LG, and LB of different colors emitted by the plurality of light-emitting structures 110R, 110G, and 110B, respectively, may form a surface light source having uniform brightness and uniform intensity.

The optical spacer layer 120 may be disposed on the peripheral insulating layer 103 and the plurality of light-emitting structures 110R, 110G, and 110B. In one or more embodiments, the optical spacer layer 120 may include a material that has a low refractive index and exhibits little or no optical loss when incident light passes through the inside of the optical spacer layer 120.

For example, the optical spacer layer 120 may include silicon oxide or polymer (e.g., polydimethylsiloxane (PDMS), SU8, polycarbonate (PC), polystyrene (PS), polymethyl methacrylate (PMMA), etc.), and the light LR, LG, and LB of different colors emitted from the light emitter 110 may pass through the optical spacer layer 120 and be then emitted in a direction toward the meta-microlens 130 which is described below.

In one or more embodiments, the thickness of the optical spacer layer 120 in a vertical direction Z may be determined by a focal length of the meta-microlens 130. That is, the light LR, LG, and LB of different colors emitted from the light emitter 110 may be refracted once when passing through the optical spacer layer 120 and may be refracted once more when passing through the meta-microlens 130. In this case, the thickness of the optical spacer layer 120 may be determined so that the light LR, LG, and LB of different colors may form the surface light source having uniform brightness and uniform intensity.

The meta-microlens 130 may include a pattern layer 131 including a plurality of holes 131H and a plurality of pillar structures 133 filling the plurality of holes 131H.

The plurality of pillar structures 133 may be arranged, on one surface of the optical spacer layer 120, in various two-dimensional arrangements. In one or more embodiments, the plurality of pillar structures 133 may be arranged in a designated arrangement in order to refract, in a desired direction, the light LR, LG, and LB incident through the optical spacer layer 120.

The plurality of pillar structures 133 may include cylindrical pillars being spaced apart by different distances S1 and S2 and having different diameters D1 and D2. In one or more embodiments, the plurality of pillar structures 133 may have a same height H1.

Here, the plurality of pillar structures 133 are shown as having two diameters D1 and D2 and being spaced apart by two distances S1 and S2, but embodiments are not limited thereto. That is, the plurality of pillar structures 133 may be formed as a plurality of cylindrical pillars that have at least two different diameters and being spaced apart by at least two different distances.

Also, the plurality of pillar structures 133 are not limited to the cylindrical pillars and may have various pillar shapes, such as a polygon, a cross, a star, and an asymmetrical shape.

The plurality of pillar structures 133 may temporarily trap part of the incident light LR, LG, and LB inside the plurality of pillar structures 133 by using the difference in refractive index with respect to the pattern layer 131. Each of the plurality of pillar structures 133 may have a dimensional element with a length shorter than a wavelength band of each of the light LR, LG, and LB emitted from the plurality of light-emitting structures 110R, 110G, and 110B, respectively. Here, the dimensional element may represent any one length element in a three-dimensional shape, such as the height and the diameter of each of the plurality of pillar structures 133. Also, the dimensional element may represent the distance between the plurality of pillar structures 133.

Since infrared light or visible light has a wavelength (λ) of several hundred nanometers, the dimensional element of each of the plurality of pillar structures 133 for transmitting and receiving the infrared light or the visible light may be less than or equal to several hundred nanometers. For example, the plurality of pillar structures 133 may have the height H1 of about 600 nm to about 700 nm and the diameter D1 or D2 of about 120 nm to about 150 nm to transmit and receive the infrared light.

Also, for example, the plurality of pillar structures 133 may be spaced apart from each other by the distance S1 or S2 of about 350 to about 400 nm. In one or more embodiments, the distance S1 or S2 between the plurality of pillar structures 133 may be less than the wavelength (λ) of each of the light LR, LG, and LB emitted from the corresponding plurality of light-emitting structures 110R, 110G, and 110B, respectively.

The refractive index of the material that constitutes the plurality of pillar structures 133 may be greater than the refractive index of the material that constitutes the pattern layer 131. For example, the material that constitutes the pattern layer 131 may include silicon oxide or resin, and the material that constitutes the plurality of pillar structures 133 may include any one of silicon, titanium oxide, hafnium oxide, and silicon nitride. However, embodiments are not limited thereto.

The meta-microlens 130 that includes the pattern layer 131 and the plurality of pillar structures 133 having the characteristics described above may serve as various optical components. For example, the meta-microlens 130 may function as various optical components, such as a convex lens, a concave lens, a prism, and a light deflector.

In the light source module 10 according to one or more embodiments, the plurality of pillar structures 133 may be arranged so as to independently adjust the angles of refraction of light according to the light LR, LG, and LB emitted from the plurality of light-emitting structures 110R, 110G, and 110B corresponding to the plurality of pillar structures 133, respectively.

That is, the plurality of pillar structures 133 may be arranged in layouts thereby providing a plurality of layouts. Each of the plurality of layouts may respectively correspond to a light-emitting structure 110R, 110G, and 110B, to independently adjust the angles of refraction of light according to the light LR, LG, and LB emitted from the plurality of light-emitting structures 110R, 110G, and 110B. Put alternatively, each of the plurality of layouts may include a sub-plurality of pillar structures 133 among the plurality of pillar structures 133. As shown in FIG. 5 and described in more detail below, the red regions MR may include a first layout of pillar structures 133, the green region MG may include a second layout of pillar structures 133, and the blue region MB may include a third layout of pillar structures 133, with each of the first to third layouts being different so as to independently adjust the angles of refraction of light according to the light LR, LG, and LB emitted from the plurality of light-emitting structures 110R, 110G, and 110B.

For example, in a red region MR of the meta-microlens 130 corresponding to the red light-emitting structure 110R, the plurality of pillar structures 133 have a first layout. Also, in a green region MG of the meta-microlens 130 corresponding to the green light-emitting structure 110G, the plurality of pillar structures 133 have a second layout. Also, in a blue region MB of the meta-microlens 130 corresponding to the blue light-emitting structure 110B, the plurality of pillar structures 133 have a third layout. Here, as shown in the diagram, at least one of the first layout, the second layout, and the third layout of the plurality of pillar structures 133 may differ from the other layouts.

In the light source module 10 according to one or more embodiments, the first layout, the second layout, and the third layout of the plurality of pillar structures 133 may be formed differently from each other. Accordingly, the refractive angles of the differently emitted light LR, LG, and LB may be adjusted independently, and thus, the light LR, LG, and LB emitted via the meta-microlens 130 may have substantially uniform straightness. This may be understood by comparison with a general curved microlens ML.

In the light source module 10 according to one or more embodiments, FIGS. 3 and 4 show a series of processes, in which the meta-microlens 130 is formed to replace the curved microlens ML, and the resulting structure.

For example, in the cross-sectional view and the plan view of the curved microlens ML, the refractive indexes of the curved microlens ML are measured in terms of an analog perspective that changes gradually, and then converted to the refractive indexes of the meta-microlens 130 in terms of a digital perspective. In this way, the meta-microlens 130 that replaces the curved microlens ML may be formed.

For example, the curved microlens ML corresponding to the red light-emitting structure 110R has a first radius. Also, the curved microlens ML corresponding to the green light-emitting structure 110G has a second radius. Also, the curved microlens ML corresponding to the blue light-emitting structure 110B has a third radius. In one or more embodiments, at least one of the first radius, the second radius, and the third radius of the curved microlens ML may differ from the other radii. Accordingly, the manufacturing process of individually forming curved microlenses ML having different radii may require a very high degree of difficulty.

In the light source module 10 according to one or more embodiments, the first layout of the plurality of pillar structures 133 may be configured to correspond to the first radius, the second layout thereof may be configured to correspond to the second radius, and the third layout thereof may be configured to correspond to the third radius, thereby independently adjusting the angles of refraction of the differently emitted light LR, LG, and LB.

Therefore, in the light source module 10 according to one or more embodiments, the light LR, LG, and LB emitted through the meta-microlens 130 may have the same or more uniform straightness compared to the light emitted through a general curved microlens ML. In addition, the difficulty in the whole manufacturing process of the light source module 10 may be efficiently reduced.

Referring to FIG. 5 and the image of FIG. 6, in the light source module 10 according to one or more embodiments, the plurality of pillar structures 133 arranged in a central region of the pixel array 110PA of the light emitter 110 may have a different layout than the plurality of pillar structures 133 arranged in an edge region of the pixel array 110PA.

That is, for the red light-emitting structure 110R located in the central region of the pixel array 110PA and the red light-emitting structure 110R located in the edge region of the pixel array 110PA, the plurality of pillar structures 133 may have different layouts. Also, for the green light-emitting structure 110G located in the central region of the pixel array 110PA and the green light-emitting structure 110G located in the edge region of the pixel array 110PA, the plurality of pillar structures 133 may have different layouts. Also, for the blue light-emitting structure 110B located in the central region of the pixel array 110PA and the blue light-emitting structure 110B located in the edge region of the pixel array 110PA, the plurality of pillar structures 133 may have different layouts.

This may be due to the following characteristics of the layouts. For example, the red light-emitting structure 110R, which is located in the central region of the pixel array 110PA, faces the plurality of light-emitting structures 110R, 110G, and 110B in four directions in a plan view. On the other hand, the red light-emitting structure 110R, which is located in the edge region of the pixel array 110PA, faces the plurality of light-emitting structures 110R, 110G, and 110B in three or two directions in a plan view. Therefore, the light LR, LG, and LB emitted according to the locations of the pixel array 110PA may be affected differently by the surroundings.

Accordingly, in order to correct an interference effect of the light LR, LG, and LB emitted from the light emitter 110 according to the locations of the pixel array 110PA, the plurality of pillar structures 133 may have different layouts according to the locations thereof.

Accordingly, the light source module 10 according to one or more embodiments may form a surface light source (see FIG. 6) in which the light LR, LG, and LB of different colors emitted from the plurality of light-emitting structures 110R, 110G, and 110B have uniform brightness and uniform intensity irrespective of locations in the pixel array 110PA (i.e., irrespective of the central region and the edge region).

Consequently, the light source module 10 according to one or more embodiments may improve the light extraction efficiency and light uniformity by including the meta-microlens 130 that may independently adjust the angles of refraction according to the light LR, LG, and LB emitted from the corresponding plurality of light-emitting structures 110R, 110G, and 110B, respectively.

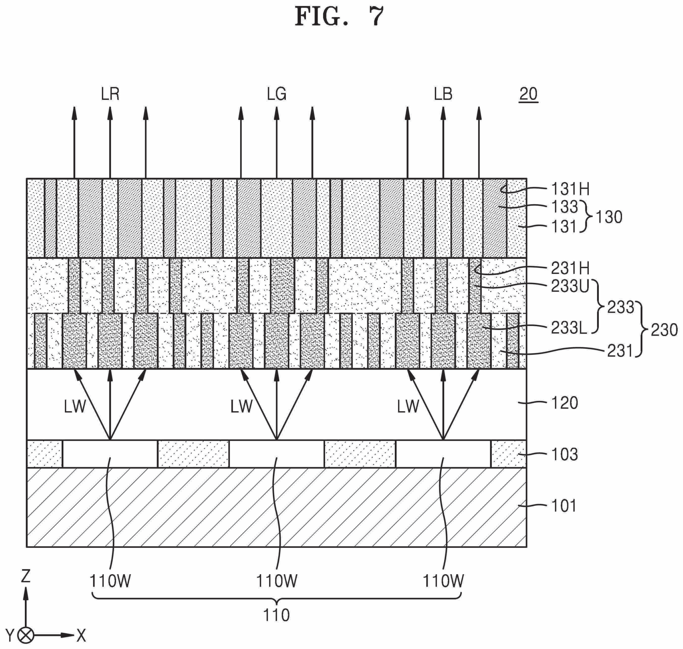

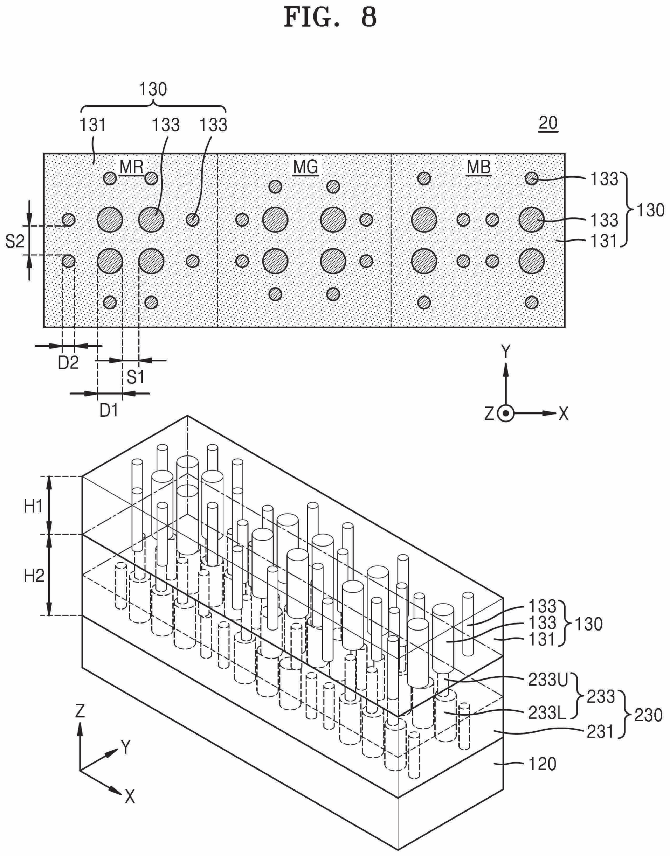

FIG. 7 is a cross-sectional view of a light source module 20 according to one or more embodiments. FIG. 8 is a diagram of a meta-microlens 130 and a meta-color filter 230 of FIG. 7 in various points of view according to one or more embodiments. Description of aspects that are the same as or similar to those described above may be omitted.

Referring to FIGS. 7 and 8 together, the light source module 20 according to one or more embodiments may include the substrate 101, the peripheral insulating layer 103, a light emitter 110, the optical spacer layer 120, a meta-color filter 230, and the meta-microlens 130.

In the light source module 20 according to one or more embodiments, the light emitter 110 may include a pixel array 110PA (see FIG. 5) in which a plurality of light-emitting structures 110W capable of emitting white light LW are arranged in a matrix form. The light emitter 110 may be disposed on one surface of the substrate 101. The light emitter 110 may, for example, emit the white light LW by selecting at least one of the plurality of light-emitting structures 110W.

In the light source module 20 according to one or more embodiments, the optical spacer layer 120 may be disposed on the peripheral insulating layer 103 and the plurality of light-emitting structures 110W. In one or more embodiments, the optical spacer layer 120 may include a material that has a low refractive index and exhibits little or no optical loss when incident light passes through the inside of the optical spacer layer 120.

For example, the optical spacer layer 120 may include silicon oxide or polymer (e.g., PDMS, SU8, PC, PS, PMMA, etc.), and the white light LW emitted from the light emitter 110 may pass through the optical spacer layer 120 and be then emitted in a direction toward the meta-color filter 230 which is described below.

The light source module 20 according to one or more embodiments may include, on the optical spacer layer 120, the meta-color filter 230 for separating the white light LW, emitted from the plurality of light-emitting structures 110W, into different colors, and the meta-microlens 130 for refracting, in predetermined directions, the light LR, LG, and LB of different colors which have been separated by the meta-color filter 230. In one or more embodiments, the upper surface of the meta-color filter 230 may directly contact the lower surface of the meta-microlens 130.

In the light source module 20 according to one or more embodiments, the meta-color filter 230 may include a unit pattern layer 231 having a plurality of unit holes 231H and a plurality of unit pillar structures 233 arranged in the plurality of unit holes 231H.

Each of the plurality of unit pillar structures 233 may include at least one pillar extending in the vertical direction Z. In one or more embodiments, the plurality of unit pillar structures 233 may include a plurality of lower pillar structures 233L and a plurality of upper pillar structures 233U above the plurality of lower pillar structures 233L in the vertical direction Z. That is, the plurality of lower pillar structures 233L and the plurality of upper pillar structures 233U may be arranged at different pitches, and in one or more embodiments, at least one of the plurality of upper pillar structures 233U may overlap at least one of the plurality of lower pillar structures 233L.

In the light source module 20 according to one or more embodiments, the meta-color filter 230 may perform color separation by utilizing the plurality of unit pillar structures 233 as nano prisms. In order to perform this function, the plurality of unit pillar structures 233 need to have a greater height than the plurality of pillar structures 133 in the vertical direction Z. Therefore, a height H2 of the meta-color filter 230 in the vertical direction Z may be greater than the height H1 of the meta-microlens 130 in the vertical direction Z. Also, in the meta-color filter 230, the refractive index of the material that constitutes the plurality of unit pillar structures 233 may be greater than the refractive index of the material that constitutes the unit pattern layer 231.

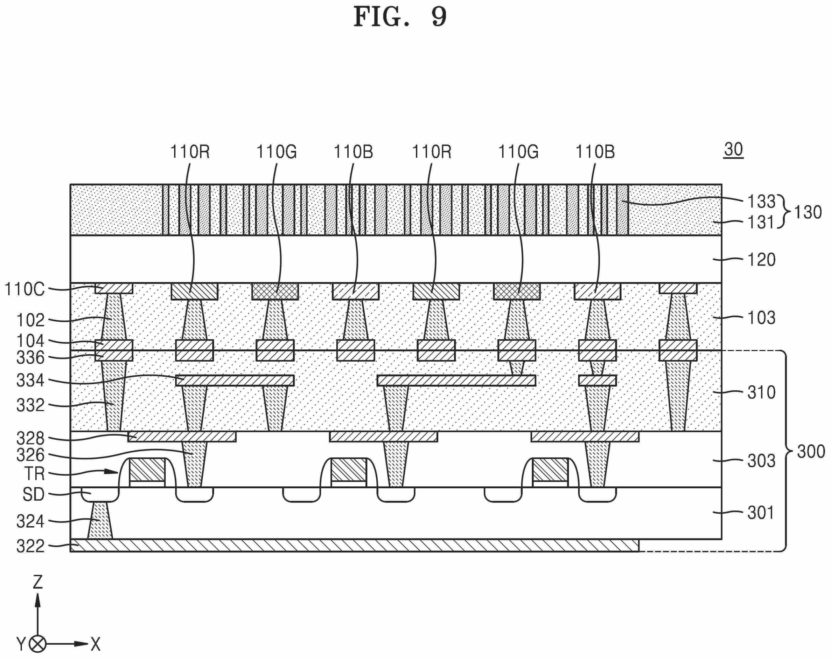

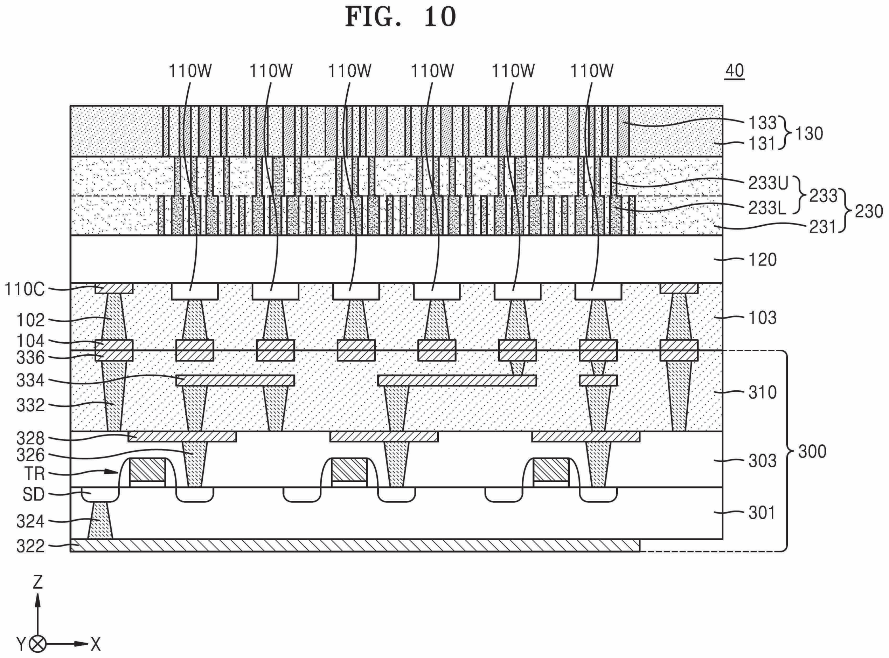

FIGS. 9 and 10 are cross-sectional views of light source modules 30 and 40, respectively, according to one or more embodiments. Description of aspects that are the same as or similar to those described above may be omitted.

Referring to FIG. 9, the light source module 30 according to one or more embodiments may include a circuit board 300, the peripheral insulating layer 103, the light emitter 110, the optical spacer layer 120, and the meta-microlens 130.

In the light source module 30 according to one or more embodiments, the peripheral insulating layer 103, the light emitter 110, the optical spacer layer 120, and the meta-microlens 130 are substantially the same as those of the light source module 10 described above.

However, a cathode electrode 110C may be further located around both ends of the plurality of light-emitting structures 110R, 110G, and 110B. The peripheral insulating layer 103 may further include therein a contact plug 102 and a first bonding pad 104 connected to the contact plug 102. The first bonding pad 104 may include copper (Cu).

In the light source module 30 according to one or more embodiments, the circuit board 300 may be a driving circuit board including a transistor TR. In one or more embodiments, the circuit board 300 may include an application-specific integrated circuit (ASIC) having a driver circuit. In one or more embodiments, the circuit board 300 may include a flexible board. In this case, the light source module 30 may be implemented as a rollable, stretchable, or curved display device.

The circuit board 300 may include a semiconductor substrate 301, a driving circuit formed on the semiconductor substrate 301 and including the transistor TR, an interconnector 326 electrically connected to the transistor TR, and a wiring line 328 connected to the interconnector 326.

The semiconductor substrate 301 may include an impurity region that constitutes the source/drain region SD of the transistor TR. The semiconductor substrate 301 may include a through-electrode 324, such as a through-silicon via (TSV) connected to the source/drain region SD, and a substrate wire 322 connected to the through-electrode 324.

The circuit board 300 may include a first insulating layer 303 that covers the transistor TR constituting the driving circuit, the interconnector 326, and the wiring line 328.

The circuit board 300 may include a second insulating layer 310 on the first insulating layer 303, and may further include a conductive plug 332 passing through the second insulating layer 310 and connected to the wiring line 328, a conductive line 334 located inside the second insulating layer 310, and a second bonding pad 336 connected to the conductive plug 332. The second bonding pad 336 may include copper (Cu).

In the light source module 30 according to one or more embodiments, a hybrid copper-to-copper bonding method may be applied in which the first bonding pad 104 and the second bonding pad 336 are bonded to each other, and the peripheral insulating layer 103 and the second insulating layer 310 are bonded to each other.

Therefore, in the light source module 30 according to one or more embodiments, the plurality of light-emitting structures 110R, 110G, and 110B each may be connected to the corresponding transistor TR via the contact plug 102, the first bonding pad 104, the second bonding pad 336, the conductive plug 332, and the interconnector 326.

Referring to FIG. 10, the light source module 40 according to one or more embodiments may include the circuit board 300, the peripheral insulating layer 103, the light emitter 110, the optical spacer layer 120, the meta-color filter 230, and the meta-microlens 130.

In the light source module 40 according to one or more embodiments, the peripheral insulating layer 103, the light emitter 110, the optical spacer layer 120, the meta-color filter 230, and the meta-microlens 130 are substantially the same as those of the light source module 20 described above. However, the cathode electrode 110C may be further located around both ends of the plurality of light-emitting structures 110W.

In the light source module 40 according to one or more embodiments, the circuit board 300 may be the driving circuit board including the transistor TR. The circuit board 300 may be substantially the same as that of the light source module 30 described above. Therefore, repeated descriptions as those given for the circuit board 300 may be omitted.

In the light source module 40 according to one or more embodiments, the hybrid copper-to-copper bonding method may be applied in which the first bonding pad 104 and the second bonding pad 336 are bonded to each other, and the peripheral insulating layer 103 and the second insulating layer 310 are bonded to each other.

Therefore, in the light source module 40 according to one or more embodiments, the plurality of light-emitting structures 110W each may be connected to the corresponding transistor TR via the contact plug 102, the first bonding pad 104, the second bonding pad 336, the conductive plug 332, and the interconnector 326.

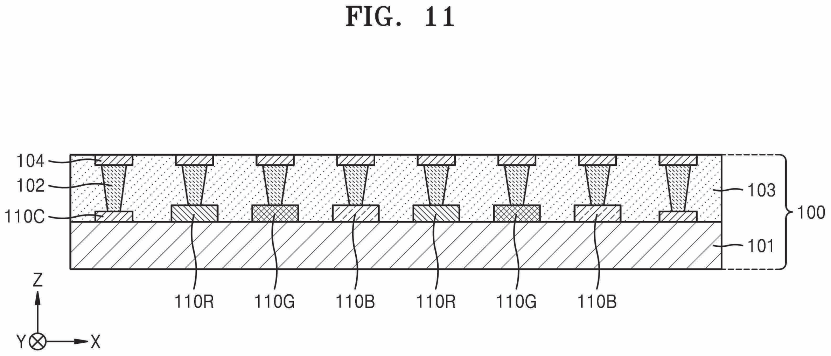

FIGS. 11, 12, 13, 14, 15, 16, 17, 18 and 19 are cross-sectional views illustrating a method of manufacturing a light source module, according to one or more embodiments. It will be understood that the order of operations in FIGS. 11-19 may be variously changed.

Referring to FIG. 11, the plurality of light-emitting structures 110R, 110G, and 110B and cathode electrodes 110C may be formed on the substrate 101.

Next, the peripheral insulating layer 103 covering the plurality of light-emitting structures 110R, 110G, and 110B and the cathode electrode 110C may be formed, and the contact plug 102 passing through the peripheral insulating layer 103 and the first bonding pad 104 connected to the contact plug 102 may be formed. Here, the first bonding pad 104 may include copper (Cu). Accordingly, a board structure 100 may be completed.

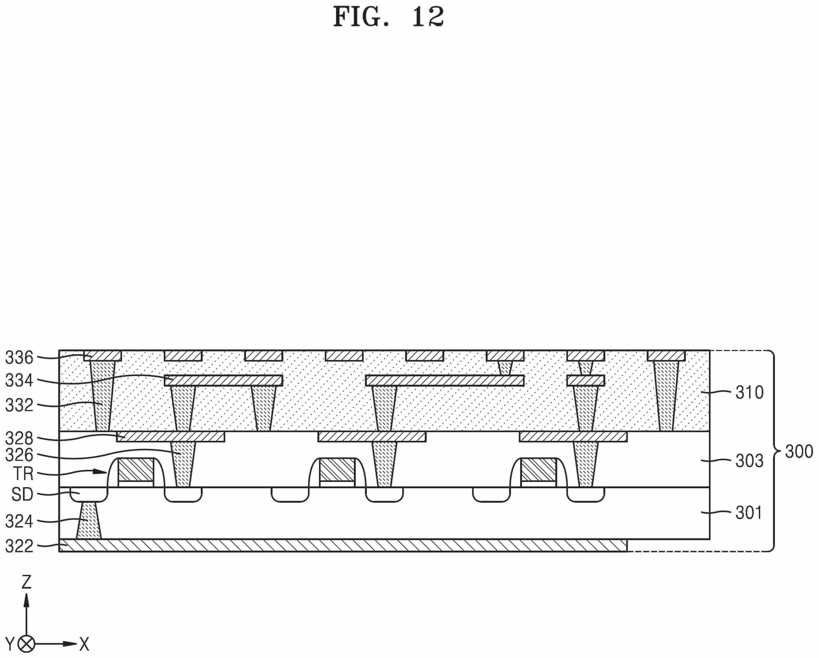

Referring to FIG. 12, the first insulating layer 303, the driving circuit including the transistor TR, the interconnector 326 electrically connected to the transistor TR, and the wiring line 328 connected to the interconnector 326 may be formed on the semiconductor substrate 301.

Next, the second insulating layer 310 may be formed on the first insulating layer 303, and the conductive plug 332 passing through the second insulating layer 310 and connected to the wiring line 328, the conductive line 334 located inside the second insulating layer 310, and the second bonding pad 336 connected to the conductive plug 332 may be formed. Here, the second bonding pad 336 may include copper (Cu).

Next, the through-electrode 324 connected to the source/drain region SD and the substrate wire 322 connected to the through-electrode 324 may be formed. Accordingly, the circuit board 300 may be completed.

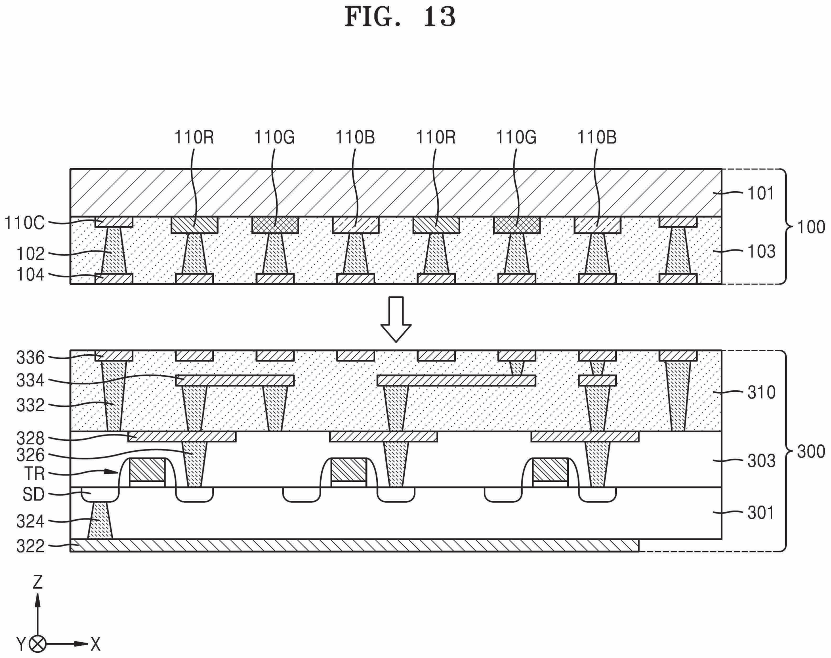

Referring to FIG. 13, the board structure 100 may be positioned above the circuit board 300. Also, the positions thereof may be accurately aligned. That is, the first bonding pad 104 of the board structure 100 may be positioned to accurately face the second bonding pad 336 of the circuit board 300.

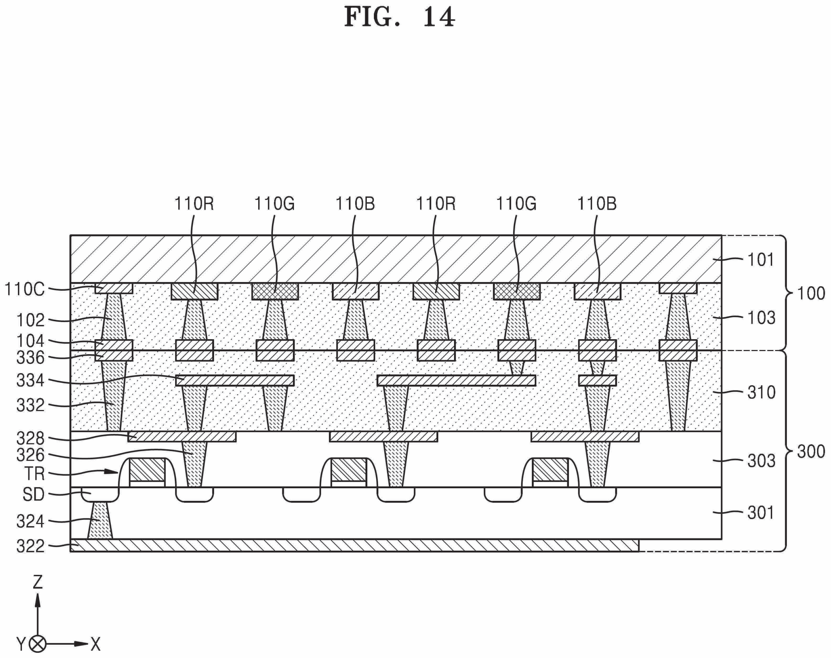

Referring to FIG. 14, the circuit board 300 may be directly bonded to the board structure 100 by heat treatment. The first bonding pad 104 may be bonded to the second bonding pad 336, and the peripheral insulating layer 103 may be bonded to the second insulating layer 310. That is, the hybrid copper-to-copper bonding method may be used to bond the circuit board 300 and the board structure 100 to each other.

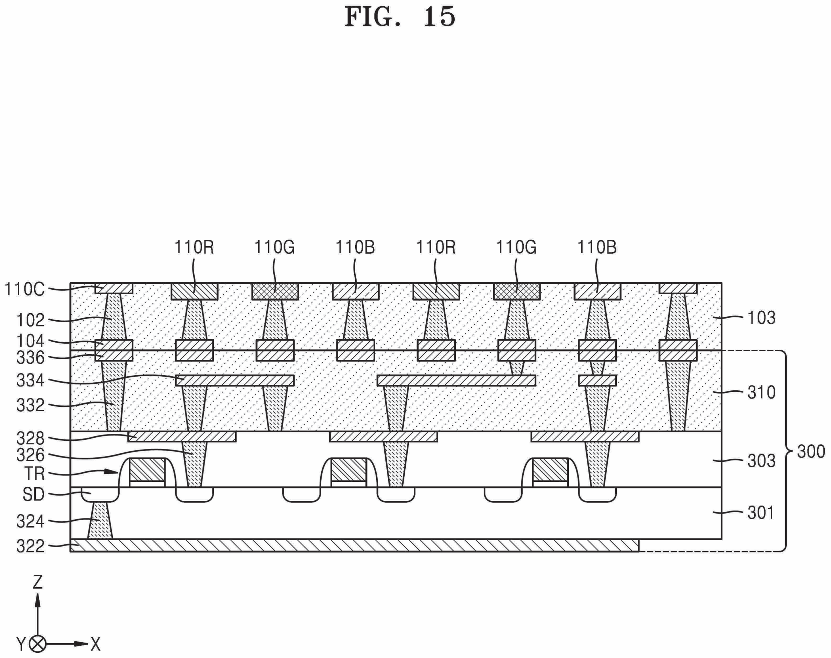

Referring to FIG. 15, a process of removing the substrate 101 from the resulting structure of FIG. 14 may be performed. The process of removing the substrate 101 may be performed by a grinding process and/or a wet etching process. Also, in the process of removing the substrate 101, the grinding process and the wet etching process may be alternately performed. Accordingly, the upper surfaces of the plurality of light-emitting structures 110R, 110G, and 110B and the upper surface of the cathode electrode 110C may be exposed to the outside.

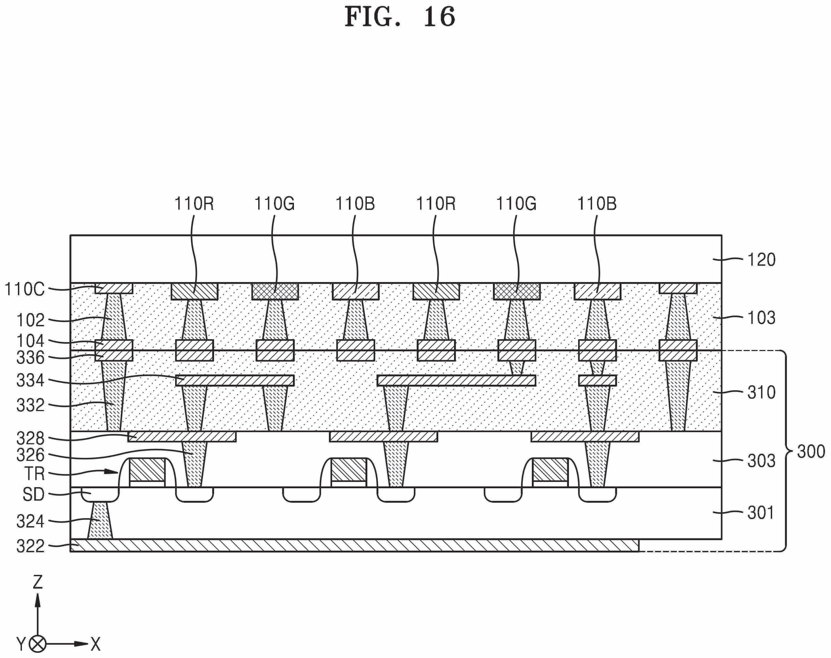

Referring to FIG. 16, the optical spacer layer 120 may be formed in the resulting structure of FIG. 15 to cover the upper surfaces of the plurality of light-emitting structures 110R, 110G, and 110B and the upper surface of the cathode electrode 110C. The optical spacer layer 120 may be formed by using the material that has a low refractive index and exhibits little or no optical loss when incident light passes through the inside of the optical spacer layer 120.

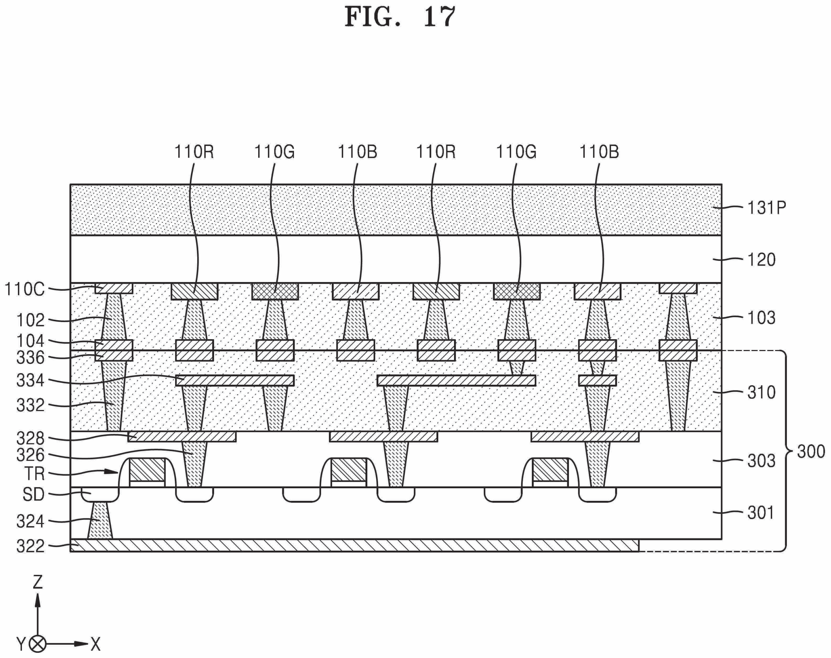

Referring to FIG. 17, a pattern forming layer 131P may be formed in the resulting structure of FIG. 16 to cover the surface of the optical spacer layer 120. The material that constitutes the pattern forming layer 131P may include, but is not limited to, silicon oxide or resin.

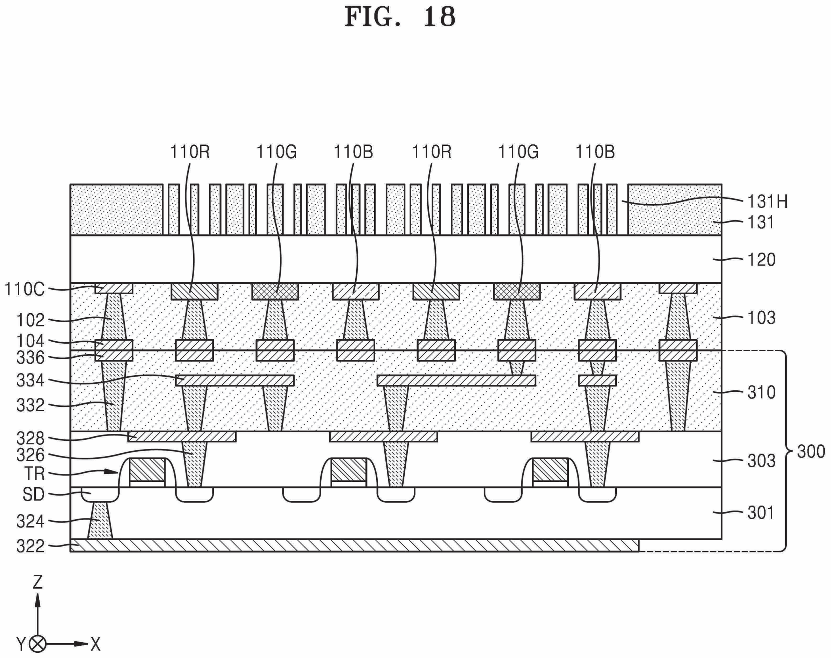

Referring to FIG. 18, a photomask may be formed above the pattern forming layer 131P in the resulting structure of FIG. 17, and the plurality of holes 131H may be formed in the pattern forming layer 131P by using the photomask as an etching mask. The plurality of holes 131H may respectively correspond to the plurality of light-emitting structures 110R, 110G, and 110B. After forming the plurality of holes 131H in the pattern forming layer 131P, the photomask may be removed. Accordingly, the pattern layer 131 including the plurality of holes 131H may be formed.

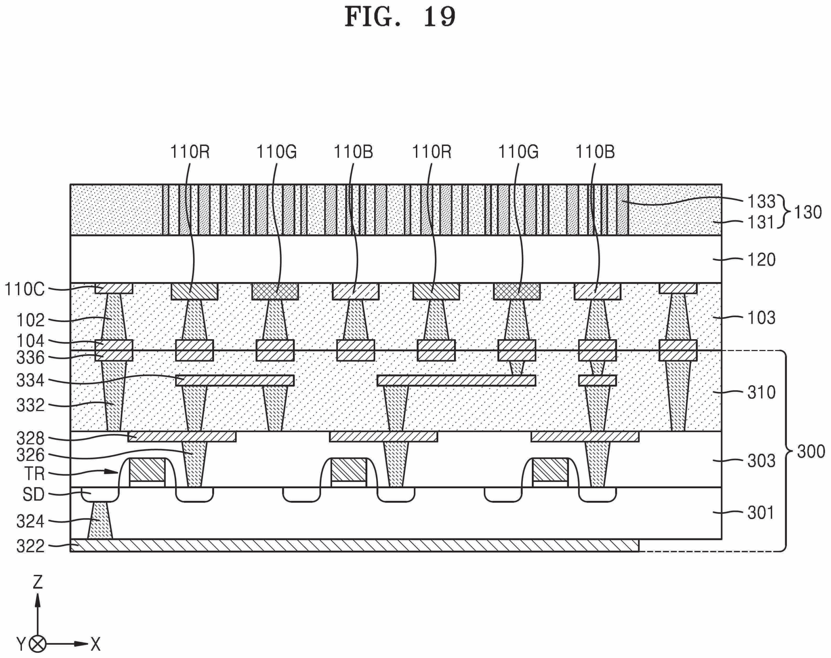

Referring to FIG. 19, the plurality of pillar structures 133 may fill all of the plurality of holes 131H formed in the pattern layer 131 of the resulting structure of FIG. 18. The plurality of pillar structures 133 may be formed on one surface of the optical spacer layer 120 in a variety of two-dimensional arrangements. The material that constitutes the plurality of pillar structures 133 may include, but is not limited to, any of silicon, titanium oxide, hafnium oxide, and silicon nitride.

By utilizing the manufacturing method described above, the light source module 30 (see FIG. 9) according to one or more embodiments may be manufactured.

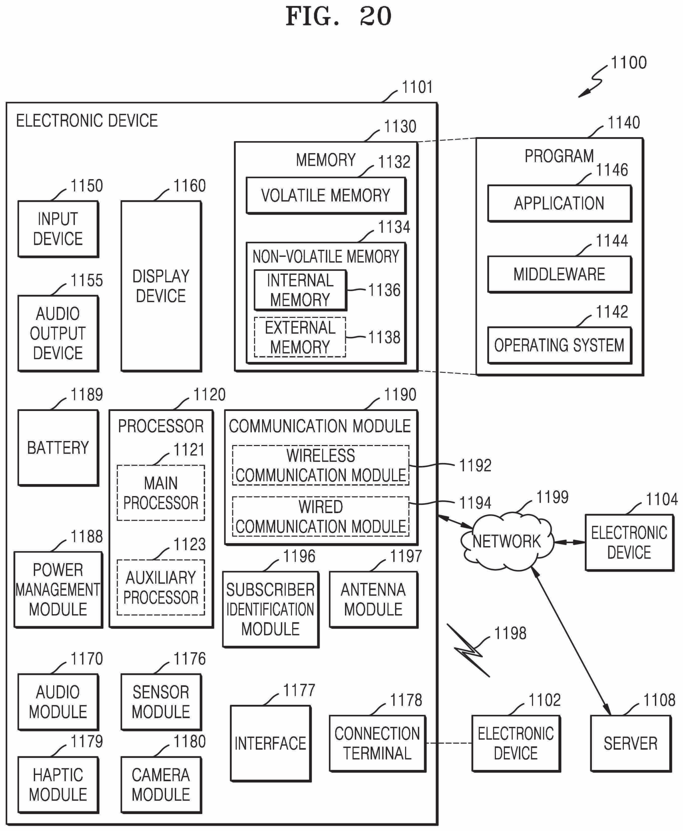

FIG. 20 is a block diagram of an electronic device 1101 including a light source module according to one or more embodiments.

Referring to FIG. 20, the electronic device 1101 may be provided inside a network environment 1100.

In the network environment 1100, the electronic device 1101 may communicate with another electronic device 1102 via a first network 1198 (a short-distance wireless communication network, etc.) or may communicate with another electronic device 1104 and/or a server 1108 via a second network 1199 (a long-distance wireless communication network, etc.). The electronic device 1101 may communicate with the electronic device 1104 via the server 1108. The electronic device 1101 may include a processor 1120, memory 1130, an input device 1150, an audio output device 1155, a display device 1160, an audio module 1170, a sensor module 1176, an interface 1177, a haptic module 1179, a camera module 1180, a power management module 1188, a battery 1189, a communication module 1190, a subscriber identification module 1196, and/or an antenna module 1197. In the electronic device 1101, some of these components may be omitted or other components may be added. Some of the components may be implemented as a single integrated circuit. For example, the sensor module 1176 (a fingerprint sensor, an iris sensor, an illuminance sensor, etc.) may be embedded in the display device 1160 (a display, etc.).

The processor 1120 may execute software (a program 1140, etc.) to control one or a plurality of other components (hardware, software components, etc.) of the electronic device 1101 connected to the processor 1120 and may perform various data processing or computing operations. As part of data processing or computing operations, the processor 1120 may load commands and/or data received from other components (the sensor module 1176, the communication module 1190, etc.) into volatile memory 1132, may process the commands and/or data stored in the volatile memory 1132, and may store the resulting data in non-volatile memory 1134. The processor 1120 may include a main processor 1121 (a central processing unit, an application processor, etc.) and an auxiliary processor 1123 (a graphics processing unit, an image signal processor, a sensor hub processor, a communication processor, etc.) capable of operating independently or together with the main processor 1121. The auxiliary processor 1123 may use less power than the main processor 1121 and perform specialized functions.

The auxiliary processor 1123 may control functions and/or states related to some of the components (the display device 1160, the sensor module 1176, the communication module 1190, etc.) of the electronic device 1101, on behalf of the main processor 1121 while the main processor 1121 is in an inactive state (a sleep state) or together with the main processor 1121 while the main processor 1121 is in an active state (an application execution state). The auxiliary processor 1123 (an image signal processor, a communication processor, etc.) may also be implemented as part of other functionally related components (the camera module 1180, the communication module 1190, etc.).

The memory 1130 may store various pieces of data needed by the components (the processor 1120, the sensor module 1176, etc.) of the electronic device 1101. The data may include, for example, input data and/or output data for software (the program 1140, etc.) and commands related thereto. The memory 1130 may include the volatile memory 1132 and/or the non-volatile memory 1134.

The program 1140 may be stored as software in the memory 1130 and include an operating system 1142, middleware 1144, and/or an application 1146.

The input device 1150 may receive commands and/or data to be used in the components (the processor 1120, etc.) of the electronic device 1101 from the outside of the electronic device 1101 (a user, etc.). The input device 1150 may include a remote controller, a microphone, a mouse, a keyboard, and/or a digital pen (a stylus pen, etc.).

The audio output device 1155 may output acoustic signals to the outside of the electronic device 1101. The audio output device 1155 may include a speaker and/or a receiver. The speaker may be used for general purposes, such as multimedia playback or recording playback, and the receiver may be used to receive incoming calls. The receiver may be integrated as part of the speaker or implemented as a separate independent device.

The display device 1160 may visually provide information to the outside of the electronic device 1101. The display device 1160 may include a display, a hologram device, or a projector, and a control circuit for controlling the devices. The display device 1160 may include the light source modules 10, 20, 30, and 40 described above. The display device 1160 may include a touch circuitry set to sense touch and/or a sensor circuitry (a pressure sensor, etc.) set to measure an intensity of force generated by the touch.

The audio module 1170 may convert sound into an electrical signal or, conversely, convert the electrical signal into the sound. The audio module 1170 may obtain sound via the input device 1150, or may output the sound via the audio output device 1155 and/or via a speaker and/or a headphone of another electronic device (the electronic device 1102, etc.) connected directly or wirelessly to the electronic device 1101.

The sensor module 1176 may sense operating conditions (the power, temperature, etc.) of the electronic device 1101 or external environmental conditions (a user state, etc.) and may generate electrical signals and/or data corresponding to the sensed conditions. The sensor module 1176 may include a gesture sensor, a gyro sensor, a barometric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 1177 may support one or more designated protocols that may be used to directly or wirelessly connect the electronic device 1101 to another electronic device (the electronic device 1102, etc.). The interface 1177 may include a high definition multimedia interface (HDMI), a universal serial bus (USB) interface, a security digital (SD) card interface, and/or an audio interface.

A connection terminal 1178 may include a connector that physically connects the electronic device 1101 to another electronic device (the electronic device 1102, etc.). The connection terminal 1178 may include an HDMI connector, a USB connector, an SD card connector, and/or an audio connector (a headphone connector, etc.).

The haptic module 1179 may convert electrical signals into mechanical stimulation (vibration, movement, etc.) or electrical stimulation that is perceived by a user through tactile or kinesthetic sense. The haptic module 1179 may include a motor, a piezoelectric element, and/or an electrical stimulation device.

The camera module 1180 may capture still images and moving images. The camera module 1180 may include a lens assembly including one or more lenses, image sensors, image signal processors, and/or flashlight. The lens assembly of the camera module 1180 may collect light that is emitted from a subject, i.e., a target to be captured.

The power management module 1188 may manage power supplied to the electronic device 1101. The power management module 1188 may be implemented as part of a power management integrated circuit (PMIC).

The battery 1189 may supply power to components of the electronic device 1101. The battery 1189 may include a non-rechargeable primary cell, a rechargeable secondary cell, and/or a fuel cell.

The communication module 1190 may establish a direct (wired) communication channel and/or a wireless communication channel between the electronic device 1101 and other electronic devices (the electronic device 1102, the electronic device 1104, the server 1108, etc.) and may support communication via the established communication channel. The communication module 1190 may operate independently from the processor 1120 (the application processor, etc.) and include one or more communication processors that support direct communication and/or wireless communication. The communication module 1190 may include a wireless communication module 1192 (a cellular communication module, a short-distance wireless communication module, a global navigation satellite system (GNSS) communication module, etc.) and/or a wired communication module 1194 (a local area network (LAN) communication module, a power line communication module, etc.). Among these communication modules, the corresponding communication module may communicate with other electronic devices via the first network 1198 (a short-distance communication network, such as Bluetooth, WiFi Direct, and infrared data association (IrDA)) or the second network 1199 (a long-distance communication network, such as a cellular network, Internet, and a computer network (LAN, wide area network (WAN), etc.)). These various types of communication modules may be integrated into a single component (a single chip, etc.) or may be implemented as a plurality of separate components (multiple chips). The wireless communication module 1192 may identify and authenticate the electronic device 1101 in the communication network, such as the first network 1198 and/or the second network 1199, by using subscriber information (an international mobile subscriber identifier (IMSI), etc.) stored in the subscriber identification module 1196.

The antenna module 1197 may transmit signals and/or power to or receive signals and/or power from the outside (other electronic devices, etc.). An antenna may include an emitter that has a conductive pattern formed on a substrate (a PCB, etc.). The antenna module 1197 may include one or a plurality of antennas. When the plurality of antennas are provided, an antenna suitable for the communication method used in the communication network, such as the first network 1198 and/or the second network 1199, may be selected from among the plurality of antennas by the communication module 1190. The signals and/or power may be transmitted or received between the communication module 1190 and other electronic devices via the selected antenna. In addition to the antenna, other components (a radio frequency integrated circuit (RFIC), etc.) may be provided as part of the antenna module 1197.

Some components of the electronic device 1101 may be connected to each other via communication methods (a bus, a general purpose input and output (GPIO), a serial peripheral interface (SPI), a mobile industry processor interface (MIPI), etc.) between peripheral devices and may exchange signals (commands, data, etc.).

The commands or data may be transmitted or received between the electronic device 1101 and the external electronic device 1104 via the server 1108 connected to the second network 1199. The other electronic devices 1102 and 1104 and the electronic device 1101 may be of the same or different types. All or some of the operations performed on the electronic device 1101 may be executed on one or more of the other electronic devices 1102 and 1104 and the server 1108. For example, when the electronic device 1101 is required to perform certain functions or services, the electronic device 1101 may request one or more other electronic devices to perform some or all of the functions or services, instead of autonomously executing the functions or services. The one or more other electronic devices that receive the request may execute additional functions or services related to the request and may transmit the result of executions to the electronic device 1101. To this end, cloud computing, distributed computing, and/or client-server computing techniques may be used.

The electronic device 1101 may be applied to various other devices. Depending on functions of the devices, various other components of the electronic device 1101 may be appropriately modified, and components appropriate for performing the functions of the devices may be added. Example applications of the electronic device 1101 are described below.

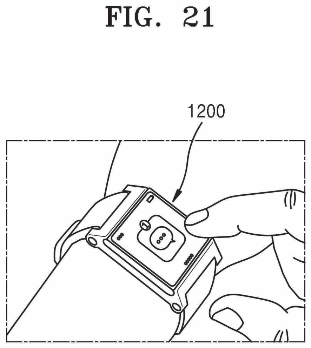

FIG. 21 is a diagram of a wearable device 1200 as an electronic device including the light source module according to one or more embodiments.

Referring to FIG. 21, the wearable device 1200 may include the light source modules 10, 20, 30, and 40 described above. The wearable device 1200 may include, for example, a smart watch worn on a wrist. The wearable device 1200 may be implemented by using the electronic device described above with reference to FIG. 20.

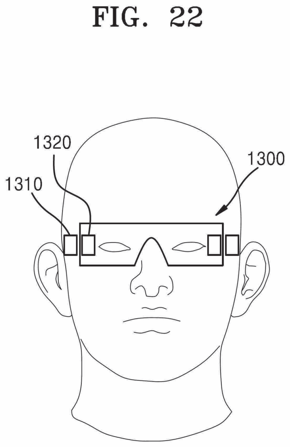

FIG. 22 is a diagram of augmented reality goggles 1300 as an electronic device including the light source module according to one or more embodiments.

Referring to FIG. 22, the augmented reality goggles (or virtual reality goggles) 1300 may include a projection system 1310 for forming an image and an element 1320 for guiding an image from the projection system 1310 into eyes of a user. The projection system 1310 may include the light source modules 10, 20, 30, and 40 described above.

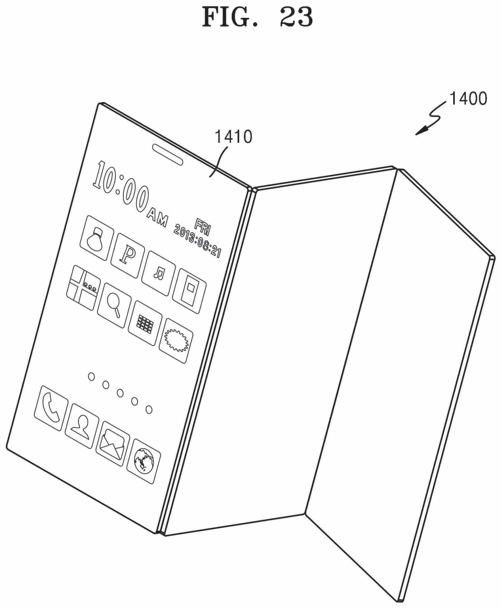

FIG. 23 is a diagram of a mobile device 1400 as an electronic device including the light source module according to one or more embodiments.

Referring to FIG. 23, the mobile device 1400 may include a display device 1410. The display device 1410 may include the light source modules 10, 20, 30, and 40 described above. The display device 1410 may have a foldable structure, for example, a multi-foldable structure.

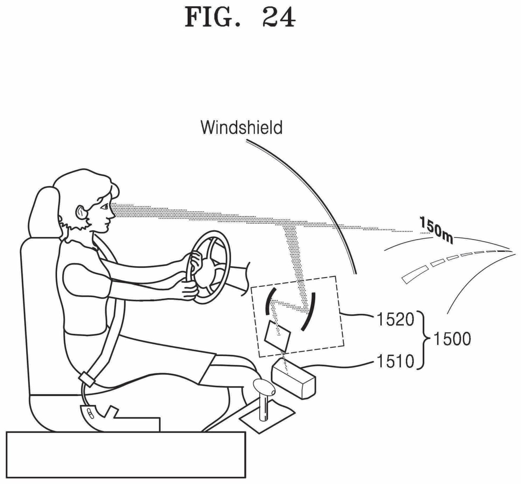

FIG. 24 is a diagram of a head-up display device 1500 as an electronic device including the light source module according to one or more embodiments.

Referring to FIG. 24, the head-up display device 1500 for an automobile may include a display 1510 provided in one region of the automobile and a light path-changing member 1520 for converting a light path so that an image generated by the display 1510 is visible to a driver. The display 1510 may include the light source modules 10, 20, 30, and 40 described above.

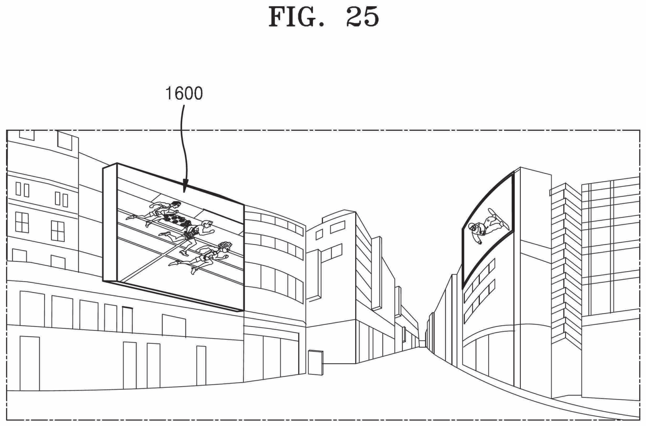

FIG. 25 is a diagram of a large signage 1600 as an electronic device including the light source module according to one or more embodiments.

Referring to FIG. 25, the signage 1600 may include the light source modules 10, 20, 30, and 40 described above. The signage 1600 may be used for outdoor advertising by using a digital information display and may control the advertising content, etc. via a communication network. The signage 1600 may be implemented, for example, by the electronic device described above with reference to FIG. 20.

In addition, the light source modules 10, 20, 30, and 40 described above may be applied to various other products, such as a rollable TV and a stretchable display, in addition to the display devices described above.

At least one of the devices, units, components, modules, units, or the like represented by a block or an equivalent indication in the above embodiments may be physically implemented by analog and/or digital circuits including one or more of a logic gate, an integrated circuit, a microprocessor, a microcontroller, a memory circuit, a passive electronic component, an active electronic component, an optical component, and the like, and may also be implemented by or driven by software and/or firmware (configured to perform the functions or operations described herein).

Each of the embodiments provided in the above description is not excluded from being associated with one or more features of another example or one or more embodiments also provided herein or not provided herein but consistent with the disclosure.

While the disclosure has been particularly shown and described with reference to embodiments thereof, it will be understood that various changes in form and details may be made therein without departing from the spirit and scope of the following claims.

## Claims

1. A light source module (10) comprising:
a substrate (101);
a light emitter (110) on the substrate (101) and comprising a pixel array (110PA) comprising a plurality of light-emitting structures (110R, 110G, 110B) configured to emit light (LR, LG, LB);
an optical spacer layer (120) on the light emitter (110) and covering the light emitter (110); and
a meta-microlens (130) on the optical spacer layer (120) and comprising a plurality of pillar structures (133) configured to refract, in predetermined directions, the light (LR, LG, LB) emitted from the plurality of light-emitting structures (110R, 110G, 110B),
wherein the plurality of pillar structures (133) are respectively arranged in a plurality of layouts, the plurality of layouts respectively corresponding to the plurality of light-emitting structures (110R, 110G, 110B), and
wherein the plurality of pillar structures (133) in each of the plurality of layouts are configured to independently adjust angles of refraction of the light (LR, LG, LB) respectively emitted from the plurality of light-emitting structures (110R, 110G, 110B).

2. The light source module (10) of claim 1, wherein a distance (S1, S2) between the plurality of pillar structures (133) in the plurality of layouts is less than a wavelength of the light (LR, LG, LB) emitted from the plurality of light-emitting structures (110R, 110G, 110B) respectively corresponding to the plurality of layouts.

3. The light source module (10) of claim 1 or 2, wherein the plurality of pillar structures (133) comprise cylindrical pillars having at least two different diameters (D1, D2) and are spaced apart by at least two different distances (S1, S2), and
wherein the plurality of layouts are configured to respectively correspond to colors of the light (LR, LG, LB) emitted by the plurality of light-emitting structures (110R, 110G, 110B).

4. The light source module (10) of any one of claims 1 to 3, wherein the plurality of pillar structures (133) have a same height (H1) in a vertical direction (Z).

5. The light source module (10) of any one of claims 1 to 4, wherein the meta-microlens (130) comprises a pattern layer (131) comprising a plurality of holes (131H),
wherein the plurality of pillar structures (133) are respectively in the plurality of holes (131H), and
wherein a material of the plurality of pillar structures (133) has a higher refractive index than a material of the pattern layer (131).

6. The light source module (10) of claim 5, wherein the material of the pattern layer (131) comprises silicon oxide, and
wherein the material of the plurality of pillar structures (133) comprises titanium oxide.

7. The light source module (10) of any one of claims 1 to 6, wherein layouts of the plurality of pillar structures (133) in a central region of the pixel array (110PA) are different from layouts of the plurality of pillar structures (133) in an edge region of the pixel array (110PA).

8. The light source module (10) of claim 7, wherein layouts of the plurality of pillar structures (133) corresponding to a first light-emitting structure of the plurality of light-emitting structures (110R, 110G, 110B) in the central region of the pixel array (110PA) are different from layouts of the plurality of pillar structures (133) corresponding to a second light-emitting structure of the plurality of light-emitting structures (110R, 110G, 110B) in the edge region of the pixel array (110PA) and that is configured to emit light of a same color as the first light-emitting structure.

9. The light source module (10) of any one of claims 1 to 8, wherein the optical spacer layer (120) has a predetermined thickness such that the light (LR, LG, LB) emitted from the plurality of light-emitting structures (110R, 110G, 110B) is directed toward the meta-microlens (130).

10. A light source module (20) comprising:
a substrate (101);
a light emitter (110) on the substrate (101) and comprising a pixel array (110) comprising a plurality of light-emitting structures (110W) configured to emit white light (LW);
an optical spacer layer (120) on the light emitter (110) and covering the light emitter (110);
a meta-color filter (230) on the optical spacer layer (120) and comprising a plurality of unit pillar structures (233) configured to separate the white light (LW) emitted from the plurality of light-emitting structures (110W) into light (LR, LG, LB) of different colors; and
a meta-microlens (130) on the meta-color filter (230) and comprising a plurality of cylindrical pillar structures (133) configured to refract, in predetermined directions, the light (LR, LG, LB) of different colors separated by the meta-color filter (230),
wherein each of the plurality of unit pillar structures (233) comprises at least one pillar extending in a vertical direction (Z),
wherein the plurality of cylindrical pillar structures (133) are respectively arranged in a plurality of layouts respectively corresponding to the plurality of light-emitting structures (110W), and
wherein the plurality of cylindrical pillar structures (133) in each of the plurality of layouts are configured to independently adjust angles of refraction of the light (LR, LG, LB) of different colors separated by the meta-color filter (230).

11. The light source module (20) of claim 10, wherein a height (H2) of the meta-color filter (230) in the vertical direction (Z) is greater than a height (H1) of the meta-microlens (130) in the vertical direction (Z).

12. The light source module (20) of claim 10 or 11, wherein the plurality of unit pillar structures (233) comprise a plurality of lower pillar structures (233L) and a plurality of upper pillar structures (233U) above the plurality of lower pillar structures (233L), and
wherein at least one of the plurality of upper pillar structures (233U) overlaps at least one of the plurality of lower pillar structures (233L).

13. The light source module (20) of claim 12, wherein the plurality of lower pillar structures (233L) have different pitches from the plurality of upper pillar structures (233U).

14. The light source module (20) of any one of claims 10 to 13, wherein the meta-color filter (230) comprises a unit pattern layer (231) comprising a plurality of unit holes (231H) and the plurality of unit pillar structures (233) respectively in the plurality of unit holes (231H),
wherein the meta-microlens (130) comprises a first pattern layer comprising a plurality of first holes and the plurality of cylindrical pillar structures (133) respectively in the plurality of first holes,
wherein a material of the plurality of unit pillar structures (233) has a higher refractive index than a material of the unit pattern layer (231), and
wherein a material of the plurality of cylindrical pillar structures (133) has a higher refractive index than a material of the first pattern layer.

15. The light source module (20) of any one of claims 10 to 14, wherein the plurality of cylindrical pillar structures (133) comprise at least two different diameters (D1, D2) and are spaced apart by at least two different distances (S1, S2), and
wherein the plurality of layouts are configured to respectively correspond to the light (LR, LG, LB) of different colors separated by the meta-color filter (230).
